# EUROPEAN PATENT SPECIFICATION

(11) **EP 3 885 971 B1**
(45) Date of publication and mention of the grant of the patent: **01.05.2024**
(21) Application number: 20165204.7
(22) Date of filing: 24.03.2020
(51) Int. Cl.: G06V 40/13

(54) **A LIGHT EMITTER/SENSOR UNIT, A DISPLAY, AND A METHOD FOR PRODUCING A DISPLAY**
LICHTEMITTER-/-SENSOREINHEIT, ANZEIGE UND VERFAHREN ZUR HERSTELLUNG EINER ANZEIGE
UNITÉ D'ÉMETTEUR/DE CAPTEUR DE LUMIÈRE, AFFICHEUR ET PROCÉDÉ DE FABRICATION D'UN AFFICHEUR

(43) Date of publication of application: 29.09.2021
(73) Proprietor: Imec VZW, 3001 Leuven (BE)
(72) Inventor: STEUDEL, Soeren, 3001 Leuven (BE); KE, Tung Huei, 3001 Leuven (BE); CHEYNS, David, 3001 Leuven (BE); MALINOWSKI, Pawel, 3001 Leuven (BE); HEREMANS, Paul, 3001 Leuven (BE)
(74) Representative: AWA Sweden AB

(56) References cited:
- EP-A1- 3 358 500
- EP-A1- 3 425 670
- US-A1- 2017 221 960
- US-A1- 2018 196 985
- US-A1- 2019 005 296

## Description

### TECHNICAL FIELD

The present invention relates to a light emitter/sensor unit, a display, and a method for producing a display.

### BACKGROUND

A display may comprise light emitting diodes arranged to form pixels which may display images. By incorporating photodiodes in the display, the display may both present images and detect objects in the vicinity of the display. This may allow for instance a fingerprint sensor to be integrated in the display such that when a finger is pressed against the display, the fingerprint may be detected. An example of a display with integrated photodiodes is e.g. described by Akkerman et al. in [Large-area Optical Fingerprint Sensors for Next Generation Smartphones, SID Symposium Digest of Technical Papers. 2019;50(1):1000-1003], Akkerman describes a photodetector array underneath a partially transparent display. Light from the display may be reflected from a finger above the display and the photodetector array underneath the display may detect the reflected light. Thus, the light may travel through the display to reach the photodetector array. To suppress scattering of the light as it passes through the display an optical collimator was placed between the display and the photodetector array.

US patent application US2019005296A1 discloses an OLED-illuminated print sensor.

US patent application US2017221960A1 discloses a contact image sensor.

European patent application EP3358500A1 discloses a display device.

### SUMMARY

It is an objective of the invention to enable a display with integrated photodiodes. It is a further objective of the invention to enable a cost-effective production of said display. It is a further objective of the invention to enable accurate detection of patterns in the vicinity of the display by the photodiodes. These and other objectives of the invention are at least partly met by the invention as defined in the independent claims.

According to a first aspect of the invention, there is provided a light emitter/sensor unit for a display according to claim 1.

The light emitter/sensor unit for a display may be part of a pixel of a display. The first TFLED may emit light which, together with light from other pixels, forms an image.

Light emitted by the first TFLED may also be reflected back towards the TFPD by an object in the vicinity of the display. The TFPD may accordingly be configured to detect reflected light originating from the first TFLED. Thus, the TFPD allows an object to be detected in the vicinity of the display.

The presence of an object, such as a finger, may be detected using one or more light emitter/sensor units. Alternatively, or additionally, a pattern of an object, such as the fingerprint of a finger, may be recorded using a plurality of light emitter/sensor units. The output (i.e. a voltage or current) from TFPDs of different pixels may be used to form an image of the object in the vicinity of the display. In the following the object will generally be described as a finger by way of example, e.g. a finger pressed against the display. However, it should be understood that the object may also be the palm of a hand, a document or another object. Thus, it should be understood that whenever the detection of a finger or the recording of a fingerprint of a finger is mentioned the reasoning applies also to the detection of another object or the recording of a pattern of another object.

An advantage of the light emitter/sensor unit is that it enables accurate detection of an object in the vicinity of the light emitter/sensor unit. Since the first and second TFPD contact surfaces, the first TFLED contact surface, and the transistors all may be comprised in a common backplane voltage regulating circuitry, these circuit elements may be arranged below the TFPD and the first TFLED. The voltage regulating circuitry may hence be arranged in such a manner with respect to the TFPD and first TFLED that obstruction of light travelling from the first TFLED to the object and back to the TFPD may be avoided.

As both the lower side of the film of the TFPD and the lower side of the film of the first TFLED are electrically connected to the same backplane voltage regulating circuitry, the TFPD and the first TFLED may be arranged side by side, i.e. to not overlap or shadow each other as seen along a light propagation path from the first TFLED to the reflecting object and back to the TFPD. Thus, light may travel from the first TFLED to the object and back to the TFPD without being scattered or obstructed. This may facilitate an accurate detection of an object in the vicinity of the light emitter/sensor unit.

In contrast, if the lower side of the film of the TFPD and the lower side of the film of the first TFLED had been electrically connected to different backplane voltage regulating circuitries arranged in different planes, a side by side arrangement of the TFPD and the first TFLED would be difficult to achieve. For example, Akkerman describes an arrangement where organic photodiodes (OPD) are arranged underneath an organic light emitting diode (OLED) display. In such an arrangement the light that is reflected by the object may need to pass through the OLED display and circuitry associated with the OLED display (e.g. a backplane associated with the OLED display) on its way to the OPD. The light may scatter as it passes through the OLED display and circuitry associated with the OLED display which may reduce the signal detected by the OPD and thereby also the signal to noise ratio.

Furthermore, as also the upper side of the film of the TFPD is electrically connected to the backplane voltage regulating circuitry, the TFPD may be individually controlled via the first and second TFPD contact surface. Thus, the driving of the TFPD may be decoupled from the driving of the first TFLED. The TFPD does not need to share any electrical contacts with the first TFLED (or any other TFLED of the light emitter/sensor unit or display). For example, the electrical potentials of the upper and lower sides of the film of the TFPD may be set to any values suitable for the operation of the TFPD independently from a biasing of the first TFLED. In contrast, had the TFPD and the first TFLED shared an electrical contact it would possibly have been necessary to set the electrical potential of said shared contact to a value that would be a compromise between optimal driving of the TFPD and optimal driving of the first TFLED. Decoupling the driving of the TFPD from the driving of the first TFLED may be particularly advantageous as the TFPD and the first TFLED may be operated with different polarity, e.g. reverse biasing the TFPD and forward biasing the first TFLED. By decoupling the driving of the TFPD from the driving of the first TFLED noise in the signal detected by the TFPD may be reduced. This may further improve the accuracy in the detection of an object in the vicinity of the light emitter/sensor unit.

Another advantage is that the light emitter/sensor unit may be produced at a low cost. When both the TFPD and the first TFLED utilize the same light emitter/sensor unit fewer process steps may be needed to produce the light emitter/sensor unit, which may facilitate cost savings.

Furthermore, when the light scattering is low along the light path from the first TFLED to the object and back to the TFPD, as facilitated by the invention, there may be no need for any additional means for scattering reduction. For example, in the display described by Akkerman, the effect of light scattering on the signal detected by the photodiode was suppressed using an optical collimator. Such a collimator may be costly to produce as it may comprise small apertures which require advanced processing.

A TFPD or a TFLED may comprise a thin film. A lateral extension of the thin film may be larger than a thickness of the thin film. The thickness may be in the range of 1 nm to 10 µm. However, in some embodiments the thickness may also be larger, e.g. in the range of 1 nm to 100 µm.

The first TFLED may e.g. comprise a light emitting layer between an electron transporting layer and a hole transporting layer. The light emitting layer may be an electroluminescent layer. Electrons may be transported to the light emitting layer from the electron transporting layer. Analogously, holes may be transported to the light emitting layer from the hole transporting layer. The electrons and holes may recombine in the light emitting layer to form light, thereby converting an electrical current to light. The light emitting layer may comprise an organic semiconductor. Thus, the first TFLED may be an organic light emitting diode (OLED). The light emitting layer may alternatively comprise quantum dots, the quantum dots being semiconductor nanocrystals. The light emitting layer may alternatively be a film of perovskite material.

The TFPD may e.g. comprise a light absorbing layer between an electron transporting layer and a hole transporting layer. The light absorbing layer may be called an active layer. The light absorbing layer may absorb light and generate an electron-hole pair. The electron-hole pair may be separated, e.g. by a built-in potential. The electron may be transported away by the electron transporting layer. The hole may be transported away by the hole transporting layer. Thus, the absorbed light may be converted into a current. The current may be measured to form a representation of an amount of light that has been absorbed. Thus, the TFPD may be operated in photoconductive mode. It should be noted that if there is no closed circuit between the electron transporting layer and the hole transporting layer the generated charge carriers may create a potential difference. The potential difference may be measured to form a representation of an amount of light that has been absorbed. Thus, the TFPD may be operated in photovoltaic mode.

The light absorbing layer may comprise an organic semiconductor. Thus, the first TFLED may be an organic photodiode (OPD). The light absorbing layer may alternatively comprise quantum dots. The light absorbing layer may alternatively be a film of perovskite material.

The material of the light emitting layer of the TFPD and the light absorbing layer of the TFPD may have a band gap. The band gap of an emitting layer may define the wavelength of the emitted light. The band gap of a light absorbing layer may define the longest wavelength light that the light absorbing layer is able to absorb. The band gap of the emitting layer of the first TFLED may be larger than the band gap of the absorbing layer of the TFPD.

The TFPD may be configured such that the electron transporting layer of the TFPD abuts the upper side of the TFPD while the hole transporting layer abuts the lower side of the TFPD. However, an opposite arrangement is also possible where the electron transporting layer of the TFPD abuts the lower side of the TFPD while the hole transporting layer abuts the upper side of the TFPD.

The first TFLED may be configured such that the electron transporting layer of the first TFLED abuts the upper side of the first TFLED while the hole transporting layer abuts the lower side of the first TFLED. However, an opposite arrangement is also possible where the electron transporting layer of the first TFLED abuts the lower side of the first TFLED while the hole transporting layer abuts the upper side of the first TFLED.

The TFPD and the first TFLED may be configured such that the electron transporting layer of the TFPD and the electron transporting layer of the first TFLED abuts the same side of their respective thin film, e.g. both abutting the upper side of their respective thin film. However, the TFPD and the first TFLED may be configured such that the electron transporting layer of the TFPD and the electron transporting layer of the first TFLED abuts opposite sides of their respective thin film, e.g. the electron transporting layer of the TFPD abutting the upper side of the TFPD and the electron transporting layer of the first TFLED abutting the lower side of the first TFLED, or vice versa.

The thin film of the first TFLED may lie, at least partially, in the same plane as the thin film of the TFPD. However, it should be understood that the thin films may be flexible. Thus, they may not necessarily form planes. The light emitter/sensor unit may have a nominal shape, e.g. the shape it was produced in or the shape it reverts to when not subjected to any external forces. The light emitter/sensor unit may be configured such that the thin film of the first TFLED lies in the same plane as the thin film of the TFPD when the light emitter/sensor unit is in its nominal shape.

The backplane voltage regulating circuitry may e.g. be a thin film transistor (TFT) backplane. The first and second TFPD contact surfaces and the first TFLED contact surface may be electrically conductive surfaces, e.g. metal surfaces, on the backplane voltage regulating circuitry, the metal surfaces being connected to the transistors of the backplane voltage regulating circuitry. As the lower side of the film of the TFPD is electrically connected to the first TFPD contact surface and the upper side of the film of the TFPD is electrically connected to the second TFPD contact surface, the electrical potential difference between the lower and upper side of the film of the TFPD may be set, or measured, via the first and second TFPD contact surface. By setting the electrical potential difference between the lower and upper side of the film of the TFPD such that the TFPD is reverse biased, the TFPD may be operated in photoconductive mode, i.e. light absorbed by the TFPD may be measured as a current. Light absorbed by the TFPD may alternatively be measured as an electrical potential difference between the lower and upper side of the film of the TFPD, i.e. the TFPD may be operated in photovoltaic mode.

Since the lower side of the film of the first TFLED is electrically connected to the first TFLED contact surface the electrical potential of the lower side of the film of the first TFLED may be set via the first TFLED contact surface. The electrical potential of the lower side of the film of the first TFLED may be set relative to an electrical potential of the upper side of the film of the first TFLED, such that an electrical potential difference between the lower and upper side of the film of the first TFLED may be controlled. The electrical potential difference may be set such that the first TFLED is forward biased and thereby emits light.

The first TFLED and the TFPD of the light emitter/sensor unit may be arranged above the backplane voltage regulating circuitry. Thus, the first TFLED and the TFPD may be arranged on the same side of the voltage regulating circuitry. This may ensure that no component which substantially scatters light is placed along the light path that goes from the first TFLED to an object and from the object to the TFPD. The first TFLED and the TFPD may e.g. be arranged side by side above the backplane voltage regulating circuitry. The first TFLED and the TFPD may e.g. be arranged at least partially in the same plane above the backplane voltage regulating circuitry.

The light emitter/sensor unit further comprises:
a bottom TFPD contact that protrudes from the first TFPD contact surface and electrically connects the first TFPD contact surface with the lower side of the film of the TFPD; and
a top TFPD contact structure comprising a lower contact part that protrudes from the second TFPD contact surface and an upper contact part, that extends laterally from the lower contact part to a position above the upper side of the film of the TFPD and connects with the upper side of the film of the TFPD, thereby electrically connecting the upper side of the film of the TFPD to the second TFPD contact surface via the upper and lower contact parts.

Thus, the top TFPD contact structure may reach and electrically connect the second TFPD contact surface to the upper side of the film of the TFPD even if the second TFPD contact surface lies below the TFPD. Through the bottom TFPD contact and the top TFPD contact structure the electrical potentials of the lower and upper sides of the film of the TFPD may be controlled from the backplane voltage regulating circuitry.

Furthermore, the top TFPD contact structure may protect the TFPD during device production: Between deposition of the TFPD film and deposition of the TFLED film a cleaning step may be needed, e.g. plasma cleaning. The top TFPD contact structure may cover the TFPD such that it does not degrade during such cleaning. Such protection may facilitate a high quality TFPD, e.g. a TFPD with a low leakage current. Such protection may additionally or alternatively facilitate a low-cost production process as the need for other protective means may be low. The top TFPD contact structure may protect the TFPD during the further production process on its own or as a part of a protective barrier, the protective barrier comprising the top TFPD contact structure and a thin film barrier layer of an electrically insulating material, e.g. SiN or Al₂O₃. Thus, the top TFPD contact structure and said thin film barrier layer may cover the TFPD such that the TFPD does not degrade during cleaning

The bottom TFPD contact and the top TFPD contact structure may be made of any electrically conductive material such as e.g. metal, indium tin oxide (ITO), MoCr, indium gallium zinc oxide (IGZO). The bottom TFPD contact and the top TFPD contact structure may not necessarily be made of the same material.

At least part of the bottom TFPD contact may be reflective. Thus, light that passes through the TFPD without being absorbed may be reflected back such that it may possibly be absorbed on the second pass through the TFPD. The material of the bottom TFPD contact may be e.g. ITO/Ag/ITO, MoCr, ITO, IGZO, IGZO/Ag/ITO etc.

The upper contact part of the top TFPD contact structure may be at least partially transparent to light of a wavelength that is detectable by the TFPD. Thus, parts of the upper side of the film of the TFPD that are covered by the upper contact part of the top TFPD contact structure may still receive detectable light. Thereby, the signal detected may be high which may improve the signal to noise ratio and enable accurate detection of an object in the vicinity of the light emitter/sensor unit. The material of the upper contact part of the top TFPD contact structure may be e.g. ITO, indium zinc oxide (IZO), aluminum zinc oxide (AZO), conductive polymers such as e.g. PEDOT:PSS, or thin metal layers such as e.g. 10 nm Ag or less than 20 nm Mg:Ag alloy with a ratio of 10:1, etc.

The light emitter/sensor unit may further comprise:
a bottom TFLED contact that electrically connects the first TFLED contact surface with the lower side of the film of the first TFLED; and
a top TFLED contact structure comprising an upper contact part, wherein the upper side of the film of the first TFLED is electrically connected to the upper contact part of the top TFLED contact structure.

Through the bottom TFLED contact and the top TFLED contact structure the electrical potentials of the lower and upper sides of the film of the first TFLED may be controlled. The electrical potential of the lower side of the film of the first TFLED may be controlled from the first TFLED contact surface. The electrical potential of the upper side of the film of the first TFLED may be controlled via the top TFLED contact structure.

The upper contact part of the top TFLED contact structure may be at least partially transparent to light that the first TFLED emits. Thus, the upper contact part of the top TFLED contact structure may, at least not fully, obstruct light from the first TFLED below. This may result in a large amount of light being transmitted, which, by extension, may result in a large amount of light being reflected by the object and detected by the TFPD. Thereby, the signal detected may be high which may improve the signal to noise ratio and enable accurate detection of an object in the vicinity of the light emitter/sensor unit.

The upper contact part of the top TFLED contact structure may be at least partially transparent to light of a wavelength that is detectable by the TFPD. Thus, the upper contact part of the top TFLED contact structure may extend above the TFPD and still allow light to be transmitted to the TFPD. Thereby, the upper contact part of the top TFLED contact structure may be produced in a simple and cost-effective manner. The upper contact part of the top TFLED contact structure may e.g. be part of a common and partially transparent top TFLED contact structure which is shared by several light emitter/sensor units of a display.

The upper contact part of the top TFPD contact structure may be closer to the backplane voltage regulating circuitry than the upper contact part of the top TFLED contact structure. Thus, the top TFLED contact structure may extend above the upper contact part of the top TFPD contact structure without interfering with the upper contact part of the top TFPD contact structure. This may facilitate providing a common top TFLED contact structure which is shared by several light emitter/sensor units of a display.

The backplane voltage regulating circuitry may be configured to turn on the TFPD by applying a first voltage between the upper and lower side of the film of the TFPD via the top and bottom TFPD contact structures. The first voltage may be a voltage that reverse biases the TFPD. The TFPD may thereby be operated in photoconductive mode.

Alternatively, the TFPD may be operated in photovoltaic mode by the backplane voltage regulating circuitry being configured to measure a voltage between the upper and lower side of the film of the TFPD via the top and bottom TFPD contact structures.

The light emitter/sensor unit may further comprise
a second TFLED, the second TFLED comprising a film with an upper side and a lower side, the film being configured to convert an electrical current into light;
wherein the backplane voltage regulating circuitry further comprises a second TFLED contact surface, and wherein the transistors of the backplane voltage regulating circuitry are further configured to set an electrical potential of the second TFLED contact surface.

A light emitter/sensor unit which comprises more than one TFLED may enable a display with good image displaying properties and/or good object detection properties. Several TFLEDs may e.g. increase the intensity of the emitted light.

The first and second TFLEDs may be configured to emit light having different spectra. Thus, the light emitter/sensor unit may emit different colors. The image displaying properties may hereby be improved. Color images, e.g. RGB images may be displayed. Furthermore, the object detection properties may also be improved. One TFLED may be used for emitting light related to displaying an image on the display while the other TFLED may be dedicated to the detection of an object in the vicinity of the display. The wavelength of the other TFLED may e.g. be configured to give a high reflectivity of the anticipated object or a low absorption or scattering in the upper contact part of the top TFPD contact structure or in the upper contact part of the top TFLED contact structure. Both the first and second TFLEDs may emit light within the visible range. Alternatively, at least one of the first and second TFLEDs may emit light outside the visible range.

The light emitter/sensor unit may further comprise
a second TFPD, the second TFPD comprising a film with an upper side and a lower side, the film being configured to absorb light and to convert absorbed light into a current.

A light emitter/sensor unit which comprises more than one TFPD may enable a display with good object detection properties. For example, one TFPD may detect one color while another TFPD may detect another color. This may enable e.g. the object's relative reflectivity of different colors being measured.

The second TFPD may be connected to a third and a fourth contact surface on the backplane voltage regulating circuitry in a manner analogous to the connection of the TFPD to the first and second TFPD contact surfaces. Alternatively, the TFPD and the second TFPD may share one contact surface. For example, the top TFPD contact structure may electrically connect both the upper side of the film of the TFPD and the upper side of the film of the second TFPD to the second TFPD contact surface on the backplane voltage regulating circuitry.

According to a second aspect of the invention, there is provided a display comprising an array of pixel areas, at least some pixel areas comprising a respective light emitter/sensor unit configured according to the first aspect,
wherein the light emitter/sensor units of the display share a common backplane voltage regulating circuitry, and
wherein the first TFPD contact surface, the second TFPD contact surface, and the first TFLED contact surface of each light emitter/sensor unit are comprised in the common backplane voltage regulating circuitry, within the respective pixel area of each light emitter/sensor unit.

A display according to the second aspect may record a pattern or image of an object in the vicinity of the display, e.g. the pattern or image of a fingerprint of a finger pressed against the display.

In some embodiments all pixels comprise a light emitter/sensor unit configured according to the first aspect. In other embodiments, only some pixels of the display comprise a light emitter/sensor unit configured according to the first aspect. For example, some pixels may comprise only TFLEDs while some pixels comprise both a TFLED and a TFPD according to the first aspect. The resolution for the recording of the pattern may not necessarily need to be as high as the resolution for displaying an image. It should also be understood that in some parts of the display there may be a higher density of light emitter/sensor units configured according to the first aspect than in other parts of the display. One region of the display may e.g. be dedicated to fingerprint recognition. For example, the bottom part of a mobile phone display, where the home button normally is situated, may be dedicated to fingerprint recognition and comprise a high density of light emitter/sensor units configured according to the first aspect.

The common backplane voltage regulating circuitry may be a TFT backplane that extends under the TFLEDs and the TFPDs of the display. A display with a common backplane voltage regulating circuitry that controls the electrical potentials of the upper and lower sides of the TFPDs and the lower sides of the TFLEDs may have several advantages, as discussed in connection with the first aspect above.

Additionally, the second aspect facilitates the TFPDs and TFLEDs being arranged side by side or arranged at least partially in the same plane above the common backplane voltage regulating circuitry. This may ensure that within a pixel area there is no component which scatters or obstructs light along the light path from the TFLED(s) of said pixel area to an object and further to the TFPD of said pixel area. It may also ensure that light that should be reflected by the object to a TFPD of a certain pixel is not scattered towards the TFPD of another pixel. Scattering of light from one pixel to another may reduce the resolution of a recorded pattern of the object. Thus, the second aspect provides a display which may accurately record a pattern of an object in the vicinity of the display.

Furthermore, the second aspect facilitates each TFPD being individually controlled as each TFPD of the light emitter/sensor units have its own first and second TFPD contact surfaces. When the TFPD of one pixel area does not share contact surfaces with the TFPD of another pixel area the TFPD noise and cross-talk between the TFPDs may be reduced. This may also facilitate accurate recording of a pattern of an object in the vicinity of the display.

Furthermore, the second aspect enables a cost-effective production of the display. With all TFPDs and all TFLEDs forming part of a common backplane voltage regulating circuitry the number of process steps in the production may be reduced. For instance, the display may not need to be assembled from two separate backplanes, one for TFPDs and one for TFLEDs.

The upper contact parts connected to the TFLEDs of the array may form part of a common top TFLED contact structure. Thereby, the upper contact part of the top TFLEDs may be produced in a simple and cost-effective manner. One large partially transparent common top TFLED contact structure may be shared by several or all light emitter/sensor units of a display.

The common top TFLED contact structure may further comprise a lower contact part. The lower contact part may protrude from a common TFLED contact surface of the backplane voltage regulating circuitry to electrically connect the upper contact parts of the top TFLED contact structure to the TFLED contact surface. The backplane voltage regulating circuitry (e.g. the transistors thereof) may be configured to set an electrical potential of the first TFLED contact surface of each light emitter/sensor unit and to set an electrical potential of the common TFLED contact surface. The backplane voltage regulating circuitry may accordingly supply a forward bias driving voltage to the TFLEDs.

The display may be configured to turn on one TFLED of a pixel area by applying a second voltage between the upper and lower side of the film of the TFLED via the common top TFLED contact structure and the bottom TFLED contact of the one TFLED. A TFLED of a pixel area may be turned on by setting the second voltage such that the TFLED is forward biased. The intensity of the emitted light from the TFLED may be increased by increasing the forward bias.

According to a third aspect of the invention, there is provided a method for producing an intermediate product of a display, the method comprising:
providing a backplane voltage regulating circuitry comprising an array of pixel areas, wherein the backplane voltage regulating circuitry comprises a first and a second TFPD contact surface and a first TFLED contact surface in at least some pixel areas, the backplane voltage regulating circuitry further comprising transistors, wherein the transistors are configured to set an electrical potential of the first TFLED contact surface and to either set electrical potentials of the two TFPD contact surfaces or to measure a potential difference between the two TFPD contact surfaces;
forming, within said at least some pixel areas,
   a bottom TFPD contact that protrudes from the first TFPD contact surface,
   a lower contact part that protrudes from the second TFPD contact surface, and
   a bottom TFLED contact that protrudes from the first TFLED contact surface;
forming, within said at least some pixel areas, a thin-film photodiode detector (TFPD) on top of, and in electrical contact with, the bottom TFPD contact, the TFPD comprising a film with an upper side and a lower side, the film being configured to absorb light and to convert absorbed light into a current; and
forming, within said at least some pixel areas, an upper contact part that extends laterally from the lower contact part to a position above the upper side of the film of the TFPD and electrically connects with the upper side of the film of the TFPD, whereby the upper and lower contact part forms a top TFPD contact structure which electrically connects the upper side of the film of the TFPD to the second TFPD contact surface.

The intermediate product of a display may be a product wherein the at least some pixel areas have been supplied with a TFPD and preparations have been made such that a first TFLED may be supplied at a later production step.

The backplane voltage regulating circuitry may be provided as a ready-made component. The backplane voltage regulating circuitry may also be manufactured as part of the production method.

Forming a bottom TFPD contact, a lower contact part, or a bottom TFLED contact may be done by depositing electrically conductive material, e.g. by evaporation or sputtering. The bottom TFPD contact, the lower contact part, and the bottom TFLED contact within one pixel area, or within several pixel areas, may be deposited simultaneously. The deposition may be done in more than one step, e.g. a first deposition of one material and a second deposition of another material. The last deposition, or the last few depositions, before the forming of the TFPD may form a reflective part of the contact or contact part.

A bottom TFLED contact may not necessarily be formed only within said at least some pixel areas. The backplane voltage regulating circuitry may comprise a first TFLED contact surface in each pixel area, i.e. not only within said at least some pixel areas. Thus, in each pixel area, a bottom TFLED contact that protrudes from the first TFLED contact surface may then be formed. The TFPD may be formed on top of the bottom TFPD contact by depositing a plurality of layers on top of the bottom TFPD contact, wherein the plurality of layers form a thin film. An electron transporting layer may be deposited on top of the bottom TFPD contact followed by a light absorbing layer, followed by a hole transporting layer. Alternatively, a hole transporting layer may be deposited on top of the bottom TFPD contact followed by a light absorbing layer, followed by an electron transporting layer. The deposition may be done by vacuum deposition or solution processing such as slot die coating, spin-coating, inkjet printing, or screen printing.

The upper contact part that extends laterally from the lower contact part to a position above the upper side of the film of the TFPD may be formed by depositing electrically conductive material, e.g. by evaporation or sputtering once the TFPD has been formed. The upper contact part may be formed from a material that is at least partially transparent to light of a wavelength that is detectable by the TFPD. The upper contact part within one pixel area, or within several pixel areas, may be deposited simultaneously.

Such a method for producing a display may be a cost-effective production method. All the TFPDs may herein be formed on a common backplane voltage regulating circuitry. Furthermore, the bottom TFLED contacts may have been prepared such that the TFLEDs may be formed on the same common backplane voltage regulating circuitry during further production steps. The further production steps may be the same production steps used for producing a display without TFPDs. Thus, after performing the method according to the third aspect, further processing may be done to finalize the display. The further processing may be done in the same production facility or at another production facility, e.g. a production facility which handles TFLED but not TFPDs.

Said further processing may further comprise:
forming, within each pixel area, a first thin-film light-emitting diode (TFLED) on top of, and in electrical contact with, the bottom TFLED contact, the first TFLED comprising a film with an upper side and a lower side, the film being configured to convert an electrical current into light; and
forming, a common top TFLED contact structure that electrically connects to the upper sides of the films of the first TFLEDs of the array of pixel areas.

The first TFLED may be formed on top of the bottom TFLED contact by depositing a plurality of layers on top of the bottom TFLED contact, wherein the plurality of layers form a thin film. An electron transporting layer may be deposited on top of the bottom TFLED contact followed by a light emitting layer, followed by a hole transporting layer. Alternatively, a hole transporting layer may be deposited on top of the bottom TFLED contact followed by a light emitting layer, followed by an electron transporting layer.

The common top TFLED contact structure may be formed by depositing electrically conductive material, e.g. by evaporation or sputtering once the TFLEDs have been formed. The common top TFLED contact structure may be formed from a material that is at least partially transparent to light that the first TFLED emits and/or is at least partially transparent to light of a wavelength that is detectable by the TFPD.

A display produced according to the third aspect of the invention may have the same advantages, or similar advantages, as the display according to the second aspect.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1a is a cross-sectional view of a light emitter/sensor unit
Fig. 1b is a top view of a light emitter/sensor unit
Fig. 2 is a cross-sectional view of a light emitter/sensor unit
Fig. 3 is a top view of a display
Fig. 4 is a flowchart of method for producing a display

### DETAILED DESCRIPTION

Hereinafter follows, in cooperation with the attached drawings, a detailed description of light emitter/sensor units and displays. Aspects of the present inventive concept may be embodied in many different forms and should not be construed as limited to the embodiments set forth herein; rather, these embodiments are provided for thoroughness and completeness, and fully convey the scope of the invention to the skilled person. It should be noted that the relative dimensions of the shown elements, such as the relative thickness of the layers, is merely schematic and may, for the purpose of illustrational clarity, differ from a physical structure. In the figures, directions X and Y may be used to indicate a first and a second horizontal direction, respectively, and Z to indicate a vertical direction. Directional qualifiers such as "horizontal" and "vertical" should hereby be understood in relation to a local frame of reference of the sensor unit(s) or display. More specifically, a horizontal direction or orientation may be understood as a direction or orientation parallel to main plane of extension of a planar structure or layer of the structure device or display, such as of backplane voltage regulating circuitry discussed below (or equivalently an upper surface of the backplane voltage regulating circuitry). Correspondingly, a vertical direction or orientation may be understood as a direction or orientation normal to the main plane of extension / upper surface of the backplane voltage regulating circuitry. As may be appreciated, terms such as "over", "above", "below", "upper", "underneath", "top" should be understood as relative positions as viewed along the vertical direction.

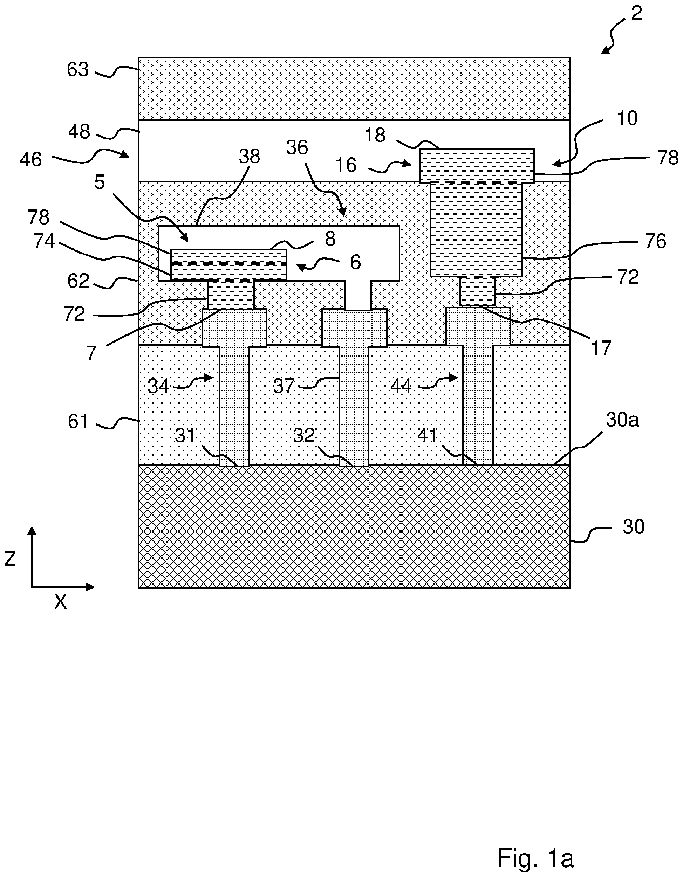

Fig. 1a is a schematic cross-sectional view of a light emitter/sensor unit 2. The light emitter/sensor unit 2 comprises a TFPD 5 and a first TFLED 10. As the figure represents a schematic view, the different parts may not necessarily be to scale. In particular, the thicknesses of the TFPD 5 and the first TFLED 10 may be smaller in relation to their lateral extension, than they appear in the figure.

The TFPD 5 comprises a film 6 with a lower side or surface 7 and an upper side or surface 8. The film 6 of the TFPD 5 in Fig. 1a comprise a light absorbing layer 74 between an electron transporting layer 72 and a hole transporting layer 78. The light absorbing layer 74 may e.g. comprise an organic semiconductor, quantum dots, or perovskite. For example, the TFPD 5 may have a light absorbing layer of PbS quantum dots, absorbing light with shorter wavelengths than 2000 µm.

The first TFLED 10 comprises a film 16 with a lower side or surface 17 and an upper side or surface 18. The film 16 of the first TFLED 10 in Fig. 1a comprise a light emitting layer 76 between an electron transporting layer 72 and a hole transporting layer 78. The light emitting layer 76 may e.g. comprise an organic semiconductor, quantum dots, or perovskite. For example, the first TFLED 10 may have a light emitting layer 76 of Ir(ppy)3, emitting green light.

An organic semiconductor may be a small molecule organic semiconductor or a polymer semiconductor. Examples of quantum dots suitable for a TFPD 5 or a first TFLED 10 are cadmium selenide quantum dots, indium phosphide quantum dots, lead sulfide quantum dots and silicon quantum dots.

The first TFLED 10 and the TFPD 5 are arranged above a backplane voltage regulating circuitry 30. The backplane voltage regulating circuitry 30 may be a TFT backplane. The backplane voltage regulating circuitry 30 comprises a first TFPD contact surface 31, a second TFPD contact surface 32, and a first TFLED contact surface 41. The contact surfaces 31, 32, 41 may as shown form part of an upper surface 30a of the backplane voltage regulating circuitry 30. Further, the backplane voltage regulating circuitry 30 comprises transistors (not shown) configured to set an electrical potential of the first TFLED contact surface 41 and to either set electrical potentials of the two TFPD contact surfaces 31, 32 or to measure a potential difference between the two TFPD contact surfaces 31, 32.

A bottom TFPD contact 34 protrudes from the first TFPD contact surface 31, through an opening in a first electrically insulating layer 61, and electrically connects the first TFPD contact surface 31 with the lower side 7 of the film 6 of the TFPD 5.

A top TFPD contact structure 36 electrically connects the upper side 8 of the film 6 of the TFPD 5 to the second TFPD contact surface 32. The top TFPD contact structure 36 comprises a lower contact part 37 that protrudes from the second TFPD contact surface 32, through an opening in the first electrically insulating layer 61. The top TFPD contact structure 36 further comprises an upper contact part 38, that extends laterally from the lower contact part 37 to a position above the upper side 8 of the film 6 of the TFPD 5 and electrically connects with the upper side 8 of the film 6 of the TFPD 5. The top TFPD contact structure 36 may be at least partially transparent to light of a wavelength that is detectable by the TFPD 5.

A bottom TFLED contact 44 electrically connects the first TFLED contact surface with the lower side 17 of the film 16 of the first TFLED 10.

A top TFLED contact structure 46 comprises an upper contact part 48, wherein the upper side 18 of the film 16 of the first TFLED 10 is electrically connected to the upper contact part 48 of the top TFLED contact structure 36.

In Fig. 1a the top TFPD contact structure 36 is closer to the backplane voltage regulating circuitry 30 than the upper contact part 48 of the top TFLED contact structure 46. Thus, the top TFLED contact structure 46 lies above the top TFPD contact structure 36. The TFPD 5 and the upper contact part 38 of the top TFPD contact structure 36 may be embedded in a second electrically insulating layer 62 such that the top TFLED contact structure 46 does not connect electrically to the TFPD 5.

The upper contact part 48 of the top TFLED contact structure 46 may be at least partially transparent to light that the first TFLED 10 emits. The upper contact part 48 of the top TFLED contact structure 46 may also be at least partially transparent to light of a wavelength that is detectable by the TFPD 5. Thus, the upper contact part 48 of the top TFLED contact structure 46 may not severely degrade the emission of light by the first TFLED 10 or the detection of light by the TFPD 5.

Above the upper contact part 48 of the top TFLED contact structure 46 there may be a third electrically insulating layer 63 which electrically insulates the upper contact part 48 of the top TFLED contact structure 46 from the surrounding of the light emitter/sensor unit 2.

The first 61, second 62, and third 63 insulating layers may be made of e.g. SiN, SiO₂, or Al₂O₃. The first 61, second 62, and third 63 insulating layers may be made of different materials. The first 61, second 62, and third 63 insulating layers may be deposited using e.g. plasma-enhanced chemical vapor deposition or atomic layer deposition.

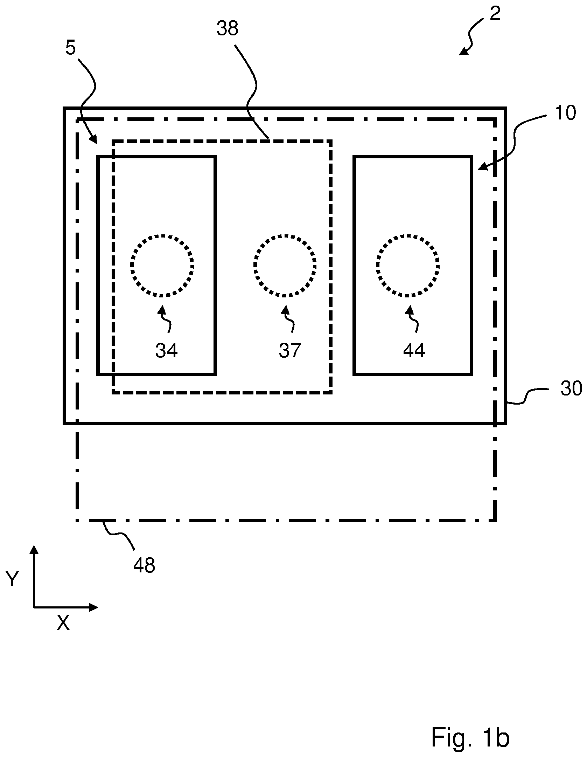

Fig. 1b is a partially transparent top view of some of the features in a light emitter/sensor unit 2. The light emitter/sensor unit 2 of Fig. 1b and the light emitter/sensor unit 2 of Fig. 1a may be the same light emitter/sensor unit 2. The partial transparency of Fig. 1b may be for illustrative purposes only. However, in embodiments of the invention some features may in fact be partially transparent, as will be further discussed.

The light emitter/sensor unit 2 of Fig. 1b has the backplane voltage regulating circuitry 30 arranged at the bottom, i.e. below the TFPD 5 and TFLED 10. The bottom TFPD contact 34, a lower contact part 37 of the top TFPD contact structure 36, and the bottom TFLED contact 44 protrudes from the backplane voltage regulating circuitry 30.

The TFPD 5 lies on top of the bottom TFPD contact 34. In the figure the bottom TFPD contact 34 only abuts a central part of a lower surface of the TFPD 5. In other embodiments the bottom TFPD contact 34 may abut most of or an entire lower surface of the TFPD 5. This may facilitate collection of created charge carriers.

The first TFLED 10 lies on top of the bottom TFLED contact 44. In the figure the bottom TFLED contact 44 only abuts a central part of a lower surface of the first TFLED 10. In other embodiments the bottom TFLED contact 44 may abut most of or an entire lower surface of the first TFLED 10.

The upper contact part 38 of the of the top TFPD contact structure 36 extends laterally from the lower contact part 37 (and connects to the upper side 8 of the film 6 of the TFPD 5 as shown in Fig. 1a). In the figure the upper contact part 38 only partially covers the TFPD 5. In other embodiments the upper contact part 38 may fully cover the TFPD 5.

The upper contact part 48 of the of the top TFLED contact structure 46 extends over the first TFLED 10 (and electrically connects to the upper side 18 of the film 16 of the first TFLED 10 as shown in Fig. 1a). As seen in the figure the upper contact part 48 of the of the top TFLED contact structure 46 may extend not only over the first TFLED 10 but also over the TFPD 5. The upper contact part 48 of the of the top TFLED contact structure 46 may extend laterally far away from the TFPD 5 and the first TFLED 10 and be connected to an electrical potential elsewhere, e.g. a further TFLED contact surface of a peripheral backplane voltage regulating circuitry area located outside the illustrated area of the light emitter/sensor unit 2.

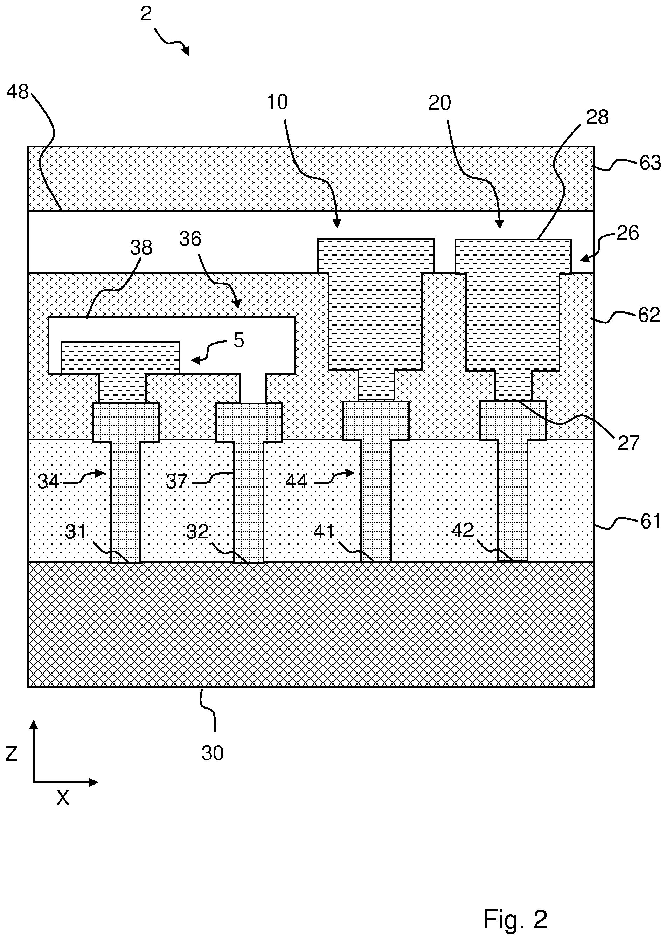

Fig. 2 illustrates a schematic cross-sectional view of a light emitter/sensor unit 2. The light emitter/sensor unit 2 of Fig. 2 comprises the same features as the light emitter/sensor unit 2 of Fig. 1a. Additionally, the light emitter/sensor 2 unit of Fig. 2 comprises a second TFLED 20. As the figure represents a schematic view, the different parts may not necessarily be to scale. In particular, the thicknesses of the TFPD 5, the first TFLED 10, and the second TFLERD 20 may be smaller in relation to their lateral extension, than they appear in the figure.

In analogy to the first TFLED 10, the second TFLED 20 comprises a film 26 with a lower side 27 and an upper side 28. The film 26 of the second TFLED 20 may comprise a plurality of layers, e.g. an electron transporting layer, a light emitting layer, and a hole transporting layer. The light emitting layer may e.g. comprise an organic semiconductor, quantum dots, or perovskite. In Fig. 2 the backplane voltage regulating circuitry 30 comprises a second TFLED contact surface 42, in addition to the first TFLED contact surface 41 and the first and second TFPD contact surfaces 31, 32.

The first 10 and second 20 TFLEDs may be configured to emit light having different spectra. For example, the first TFLED 10 may have a light emitting layer of ir(ppy)3, emitting green light, while the second TFLED 20 may have a light emitting layer of Eu(dbm)3(phen), emitting red light.

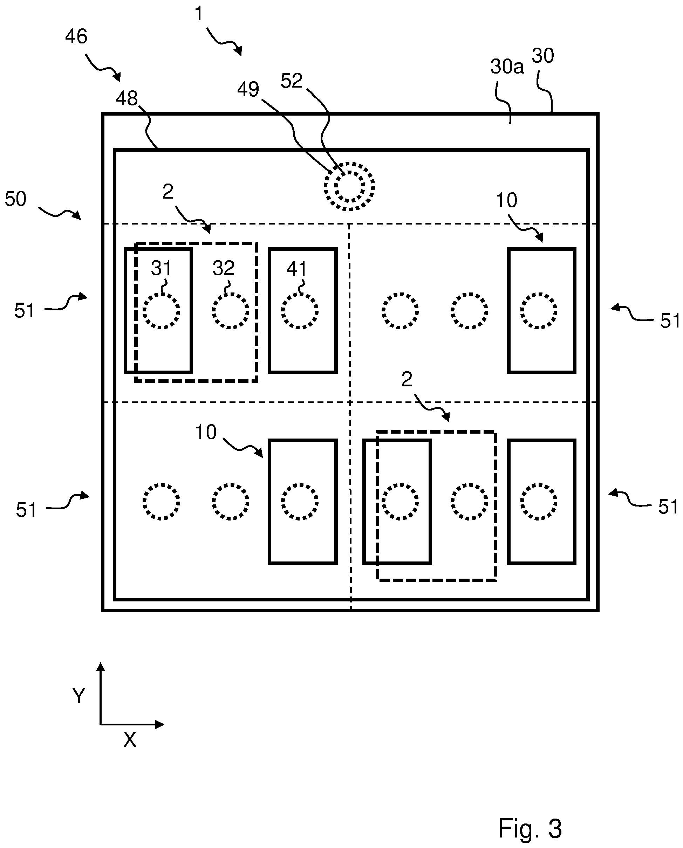

Fig. 3 illustrates a (partially transparent) top view of a display 1. The display 1 comprises an array 50 of pixel areas 51. The pixel areas 51 may be arranged in a plurality of rows and columns. For example, direction X may correspond to a row direction while direction Y may correspond to a column direction. Some pixel areas 51 comprises a light emitter/sensor unit 2 analogous to the light emitter/sensor unit 2 illustrated in Fig. 1. In the illustrated display 1 half of the pixel areas 51 comprise a light emitter/sensor unit 2. However, the fraction of pixel areas 51 that comprise a light emitter/sensor unit 2 may be different in different embodiments. For example, all of the pixel areas 51 may comprise a light emitter/sensor unit 2, or a fourth of the pixel areas 51 may comprise a light emitter/sensor unit 2. In the figure, the pixel areas which lack a light emitter/sensor unit 2 instead comprise a first TFLED 10.

In the figure the light emitter/sensor units 2 of the display 1 share a common backplane voltage regulating circuitry 30. That is, a first TFPD contact surface 31, a second TFPD contact surface 32, and a first TFLED contact surface 41 of each light emitter/sensor unit 2 within each pixel area 51 form part of the upper surface 30a of the backplane voltage regulating circuitry 30 (which e.g. may be a TFT plane). Furthermore, the light emitter/sensor units 2 of the display 1 share a common top TFLED contact structure 46 comprising upper contact parts 48 which electrically connects to the TFLEDs of the light emitter/sensor units 2, as described in connection with figures 1a, b and 2. The common top TFLED contact structure 46 and common upper contact part 48 may additionally electrically connect to the TFLEDs of the pixels that lack a light emitter/sensor unit 2. The common top TFLED contact structure 46 may, in addition to the upper contact part 48, have a lower contact part 49 which electrically connects the upper contact part 48 to the common backplane voltage regulating circuitry 30. The backplane voltage regulating circuitry 30 may for example comprise a common TFLED contact surface 52. The contact surface 52 may form part of the upper surface 30a of the backplane voltage regulating circuitry 30. The contact surface 52 may for example be arranged in a peripheral area of the backplane voltage regulating circuitry 30, or at a suitable position within the array 50. The lower contact part 49 may protrude from the contact surface 52 to electrically connect the upper contact part 48 to the TFLED contact surface 52. Thereby, the common backplane voltage regulating circuitry 30 may set an electrical potential of the upper side of all TFLEDs of the light emitter/sensor units 2 simultaneously.

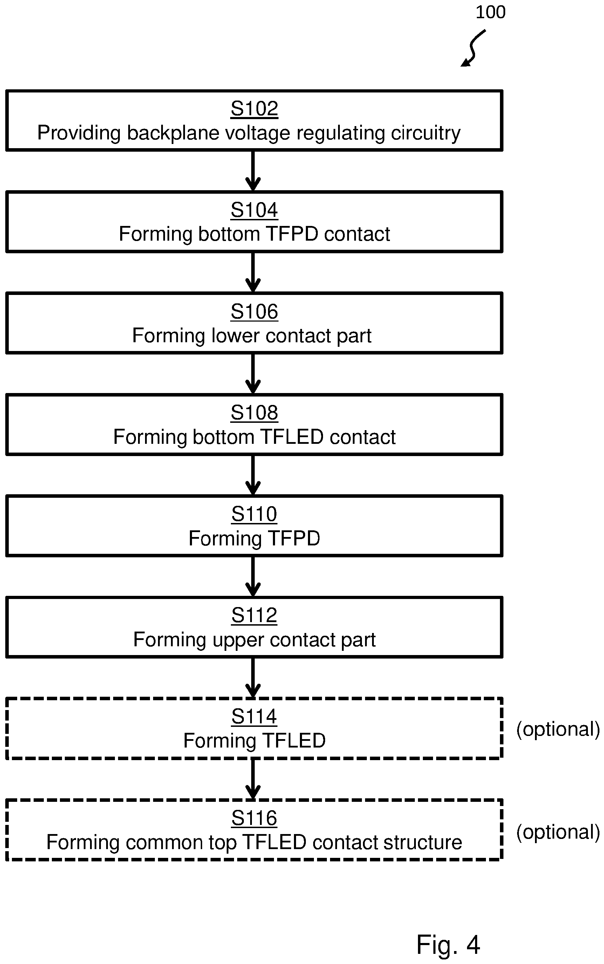

Fig. 4 shows a flowchart of method 100 for producing a display 1. The method 100 comprises providing S102 a backplane voltage regulating circuitry 30. The backplane voltage regulating circuitry 30 may be divided into pixel areas 51 forming an array 50, wherein each pixel area 51 represents an area of the backplane voltage regulating circuitry 30 within which a pixel is to be formed. At least some pixel areas 51 may be dedicated for light emitter/sensor units 2. In such pixel areas 51 the backplane voltage regulating circuitry 30 comprise a first 31 and a second 32 TFPD contact surface and a first TFLED contact surface 41. In some embodiments the pixel areas 51 of the backplane voltage regulating circuitry 30 may also comprise a second TFLED contact surface 42.

The method 100 further comprises, within said at least some pixel areas 51, forming S104 a bottom TFPD contact 34 that protrudes from the first TFPD contact surface 31, forming S106 a lower contact part 37 that protrudes from the second TFPD contact surface 32, and forming S108 a bottom TFLED contact 44 that protrudes from the first TFLED contact surface 41. The forming of the contacts S104, S106, S108 may be done simultaneously by depositing a first electrically insulating layer 61 on the backplane voltage regulating circuitry 30, creating openings (e.g. by lithography and etching) in the first electrically insulating layer 61 above the first 31 and second 32 TFPD contact surfaces and the first TFLED contact surface 41, after which the contacts may be formed, e.g. evaporated, into the openings. The first electrically insulating layer 61 may be an interlayer.

The method 100 further comprises, forming S110, within said at least some pixel areas 51, a TFPD 5 on top of the bottom TFPD contact 34. A pixel definition layer (e.g. SiN, SiO₂, Al₂O₃) may be deposited on top of the first electrically insulating layer 61 and an opening may be formed (e.g. formed by etching at a lithographically defined position) through the pixel definition layer at a location corresponding to the bottom TFPD contact 34.

In a first embodiment of the method 100, an opening through the pixel definition layer at a location corresponding to the lower contact part 37 of the top TFPD contact structure 36 is formed simultaneously with the opening at the bottom TFPD contact 34.

In a second embodiment of the method 100, an opening through the pixel definition layer at a location corresponding to the lower contact part 37 of the top TFPD contact structure 36 and an opening at a location corresponding to the bottom TFLED contact 44 is formed simultaneously with the opening at the bottom TFPD contact 34.

After the forming of an opening at a location corresponding to the bottom TFPD contact 34 the TFPD 5 may be deposited into the opening, e.g. by deposition of an electron transporting layer followed by deposition of a light absorbing layer, followed by deposition of a hole transporting layer, such that the three layers form a thin film 6. Deposition into other openings, e.g. the opening for the lower contact part 37 of the top TFPD contact structure 36 or the opening for the bottom TFLED contact 44, may be avoided by protecting such openings with a photoresist and lithographically defining the deposition area only on top of the bottom TFPD contact 34.

The method 100 further comprises forming S112, within said at least some pixel areas, an upper contact part 38 that extends laterally from the lower contact part 37 to a position above the upper side of the film of the TFPD 5 and electrically connects with the upper side of the film 6 of the TFPD 5. The upper contact part 38 may be deposited e.g. through evaporation and the lateral extension of the upper contact part 38 may be defined through lithography.

After forming S112 the upper contact part 38 a thin film barrier layer (e.g. SiN, SiO₂, Al₂O₃) may be deposited. The thin film barrier layer and the pixel definition layer may together form a second electrically insulating layer 62 into which the upper contact part 38 is embedded. Thus, the thin film barrier layer may electrically insulate the upper contact part 38 from components deposited on top of the thin film barrier layer.

An additional, optional, step of the method 100 may be forming S114, within said at least some pixel areas, a first TFLED 10 on top of the bottom TFLED contact 44. An opening may be formed through the thin film barrier layer at a location corresponding to the bottom TFLED contact 44. The opening may also be formed through the pixel definition layer unless this is not already done (as in the second embodiment of the method). Once the opening is formed, the first TFLED 10 may be deposited into the opening, e.g. by deposition of an electron transporting layer followed by deposition of a light emitting layer, followed by deposition of a hole transporting layer, such that the three layers form a thin film 16. The location of the first TFLED 10, on top of the bottom TFLED contact 44, may be defined through a lithographic process.

Another additional, optional, step of the method 100 may be forming S116, a common top TFLED contact structure 46 that electrically connects to the upper sides of the films 16 of the first TFLEDs 10 of the array of pixel areas. The common top TFLED contact structure 46 may e.g. be evaporated onto the previously formed structure. The common top TFLED contact structure 46 may be separated from the upper contact part 38 of the top TFPD contact structure 36 by a thin film barrier layer which was previously described.

The description contains a limited number of examples. However, as is readily appreciated by a person skilled in the art, other examples than the ones disclosed above are equally possible within the scope of defined by the appended claims.

## Claims

1. A light emitter/sensor unit (2) for a display (1), the light emitter/sensor unit (2) comprising:
a thin-film photodiode detector, TFPD, (5) comprising a film (6) with an upper side (8) and a lower (7) side, the film (6) being configured to absorb light and to convert absorbed light into a current;
a first thin-film light-emitting diode, TFLED, (10) comprising a film (16) with an upper side (18) and a lower side (17), the film (16) being configured to convert an electrical current into light;
backplane voltage regulating circuitry (30) comprising first (31) and second (32) TFPD contact surfaces, a first TFLED contact surface (41), and transistors, wherein the transistors are configured to set an electrical potential of the first TFLED contact surface (41) and to either set electrical potentials of the two TFPD contact surfaces (31, 32) or to measure a potential difference between the two TFPD contact surfaces (31, 32);
wherein the lower side (17) of the film (16) of the first TFLED (10) is electrically connected to the first TFLED contact surface (41), and wherein the lower side (7) of the film (6) of the TFPD (5) is electrically connected to the first TFPD contact surface (31) and the upper side (8) of the film (6) of the TFPD (5) is electrically connected to the second TFPD contact surface (32);
**characterized in that** the light emitter/sensor unit further comprises:
a bottom TFPD contact (34) that protrudes from the first TFPD contact surface (31) and electrically connects the first TFPD contact surface (31) with the lower side (7) of the film (6) of the TFPD (5); and
a top TFPD contact structure (36) comprising a lower contact part (37) that protrudes from the second TFPD contact surface (32) and an upper contact part (38), that extends laterally from the lower contact part (37) to a position above the upper side of the film (6) of the TFPD (5) and connects with the upper side (8) of the film (6) of the TFPD (5), thereby electrically connecting the upper side (8) of the film (6) of the TFPD (5) to the second TFPD contact surface (32) via the upper (38) and lower (37) contact parts.

2. The light emitter/sensor unit (2) of claim 1, wherein the first TFLED (10) and the TFPD (5) are arranged above the backplane voltage regulating circuitry (30).

3. The light emitter/sensor unit (2) of claim 2, wherein the upper contact part (38) of the top TFPD contact structure (36) is at least partially transparent to light of a wavelength that is detectable by the TFPD (5).

4. The light emitter/sensor unit (2) of any one of the preceding claims, further comprising:
a bottom TFLED contact (44) that electrically connects the first TFLED contact surface (41) with the lower side (17) of the film (16) of the first TFLED (10); and
a top TFLED contact structure (46) comprising an upper contact part (48), wherein the upper side (17) of the film (16) of the first TFLED (10) is electrically connected to the upper contact part (48) of the top TFLED contact structure (46).

5. The light emitter/sensor unit (2) of claim 4, wherein the upper contact part (48) of the top TFLED contact structure (46) is at least partially transparent to light that the first TFLED (10) emits.

6. The light emitter/sensor unit (2) of claim 4 or 5, wherein the upper contact part (48) of the top TFLED contact structure (46) is at least partially transparent to light of a wavelength that is detectable by the TFPD (5).

7. The light emitter/sensor unit (2) of any one of claims 4-6, wherein the upper contact part (38) of the top TFPD contact structure (36) is closer to the backplane voltage regulating circuitry (30) than the upper contact part (48) of the top TFLED contact structure (46).

8. The light emitter/sensor unit (2) of any one of the preceding claims, wherein the backplane voltage regulating circuitry (30) is configured to turn on the TFPD (5) by applying a first voltage between the upper and lower side (7) of the film (6) of the TFPD (5) via the top and bottom TFPD contact structures.

9. The light emitter/sensor unit (2) of any one of the preceding claims, wherein the light emitter/sensor unit (2) further comprises
a second TFLED (20), the second TFLED (20) comprising a film (26) with an upper side (28) and a lower side (27), the film (26) being configured to convert an electrical current into light;
wherein the backplane voltage regulating circuitry (30) further comprises a second TFLED contact surface (42), and wherein the transistors of the backplane voltage regulating circuitry (30) are further configured to set an electrical potential of the second TFLED contact surface (42).

10. The light emitter/sensor unit (2) of claim 9, wherein the first (10) and second (20) TFLEDs are configured to emit light having different spectra.

11. A display (1) comprising an array (50) of pixel areas (51), at least some pixel areas (51) comprising a respective light emitter/sensor unit (2) configured according to any one of the preceding claims,
wherein the light emitter/sensor units (2) of the display (1) share a common backplane voltage regulating circuitry, and
wherein the first TFPD contact surface (31), the second TFPD contact surface (32), and the first TFLED contact surface (41) of each light emitter/sensor unit (2) are comprised in the common backplane voltage regulating circuitry, within the respective pixel area (51) of each light emitter/sensor unit (2).

12. The display (1) of claim 11, wherein the upper contact parts connected to the TFLEDs of the array (50) form part of a common top TFLED contact structure.

13. The display (1) of claim 12 wherein the display (1) is configured to turn on one TFLED of a pixel area (51) by applying a second voltage between the upper and lower side of the film of the TFLED via the common top TFLED contact structure and the bottom TFLED contact of the one TFLED.

14. A method (100) for producing an intermediate product of a display (1), the method (100) comprising:
providing (S102) a backplane voltage regulating circuitry (30) comprising an array (50) of pixel areas (51), wherein the backplane voltage regulating circuitry (30) comprises a first (31) and a second (32) TFPD contact surface and a first TFLED contact surface (41) in at least some pixel areas (51), the backplane voltage regulating circuitry (30) further comprising transistors, wherein the transistors are configured to set an electrical potential of the first TFLED contact surface (41) and to either set electrical potentials of the two TFPD contact surfaces or to measure a potential difference between the two TFPD contact surfaces;
forming (S104, S106, S108), within said at least some pixel areas (51),
a bottom TFPD contact (34) that protrudes from the first TFPD contact surface (31),
a lower TFPD contact part (37) that protrudes from the second TFPD contact surface (32), and
a bottom TFLED contact (44) that protrudes from the first TFLED contact surface (41);
**characterized in that** the method further comprises:
forming (S110), within said at least some pixel areas (51), a thin-film photodiode detector, TFPD, (5) on top of, and in electrical contact with, the bottom TFPD contact (34), the TFPD (5) comprising a film (6) with an upper side (8) and a lower side (7), the film (6) being configured to absorb light and to convert absorbed light into a current; and
forming (S112), within said at least some pixel areas (51), an upper TFPD contact part (38) that extends laterally from the lower TFPD contact part (37) to a position above the upper side (8) of the film (6) of the TFPD (5) and electrically connects with the upper side (8) of the film (6) of the TFPD (5), whereby the upper (38) and lower (37) contact part forms a top TFPD contact structure (36) which electrically connects the upper side (8) of the film (6) of the TFPD (5) to the second TFPD contact surface.

## Patentansprüche

1. Licht-Emitter/Sensor-Einheit (2) für eine Anzeige (1), wobei die Licht-Emitter/Sensor-Einheit (2) umfasst:
einen Dünnschicht-Photodiodendetektor, TFPD, (5), der eine Schicht (6) mit einer oberen Seite (8) und einer unteren Seite (7) umfasst, wobei die Schicht (6) dazu konfiguriert ist, Licht zu absorbieren und das absorbierte Licht in Strom umzuwandeln;
eine erste Dünnschicht-Leuchtdiode, TFLED, (10), die eine Schicht (16) mit einer oberen Seite (18) und einer unteren Seite (17) umfasst, wobei die Schicht (16) dazu konfiguriert ist, einen elektrischen Strom in Licht umzuwandeln;
Schaltungen (30) zum Regulieren einer Rückwandplatinenspannung, die erste (31) und zweite (32) TFPD-Kontaktflächen, eine erste TFLED-Kontaktfläche (41) und Transistoren umfassen, wobei die Transistoren dazu konfiguriert sind, ein elektrisches Potential der ersten TFLED-Kontaktfläche (41) einzustellen, und entweder die elektrischen Potentiale der beiden TFPD-Kontaktflächen (31, 32) einzustellen oder eine Potentialdifferenz zwischen den beiden TFPD-Kontaktflächen (31, 32) zu messen;
wobei die untere Seite (17) der Schicht (16) der ersten TFLED (10) mit der ersten TFLED-Kontaktfläche (41) elektrisch verbunden ist, und wobei die untere Seite (7) der Schicht (6) des TFPD (5) mit der ersten TFPD-Kontaktfläche (31) elektrisch verbunden ist, und die obere Seite (8) der Schicht (6) des TFPD (5) mit der zweiten TFPD-Kontaktfläche (32) elektrisch verbunden ist;
**dadurch gekennzeichnet, dass** die Licht-Emitter/Sensor-Einheit ferner umfasst:
einen unteren TFPD-Kontakt (34), der aus der ersten TFPD-Kontaktfläche (31) vorsteht und die erste TFPD-Kontaktfläche (31) mit der unteren Seite (7) der Schicht (6) des TFPD (5) elektrisch verbindet; und
eine obere TFPD-Kontaktstruktur (36), die ein unteres Kontaktteil (37), das aus der zweiten TFPD-Kontaktfläche (32) vorsteht, und ein oberes Kontaktteil (38), das sich seitlich von dem unteren Kontaktteil (37) bis zu einer Position über der oberen Seite der Schicht (6) des TFPD (5) erstreckt und mit der oberen Seite (8) der Schicht (6) des TFPD (5) verbunden ist, umfasst, wodurch es die obere Seite (8) der Schicht (6) des TFPD (5) mit der zweiten TFPD-Kontaktfläche (32) über die oberen (38) und unteren (37) Kontaktteile elektrisch verbindet.

2. Licht-Emitter/Sensor-Einheit (2) nach Anspruch 1, wobei die erste TFLED (10) und der TFPD (5) über den Schaltungen (30) zum Regulieren einer Rückwandplatinenspannung angeordnet sind.

3. Licht-Emitter/Sensor-Einheit (2) nach Anspruch 2, wobei das obere Kontaktteil (38) der oberen TFPD-Kontaktstruktur (36) für Licht einer Wellenlänge, die durch den TFPD (5) detektierbar ist, mindestens teilweise transparent ist.

4. Licht-Emitter/Sensor-Einheit (2) nach einem der vorhergehenden Ansprüche, ferner umfassend:
einen unteren TFLED-Kontakt (44), der die erste TFLED-Kontaktfläche (41) mit der unteren Seite (17) der Schicht (16) der ersten TFLED (10) elektrisch verbindet; und
eine obere TFLED-Kontaktstruktur (46), die ein oberes Kontaktteil (48) umfasst, wobei die obere Seite (17) der Schicht (16) der ersten TFLED (10) mit dem oberen Kontaktteil (48) der oberen TFLED-Kontaktstruktur (46) elektrisch verbunden ist.

5. Licht-Emitter/Sensor-Einheit (2) nach Anspruch 4, wobei das obere Kontaktteil (48) der oberen TFLED-Kontaktstruktur (46) für Licht, das die erste TFLED (10) emittiert, mindestens teilweise transparent ist.

6. Licht-Emitter/Sensor-Einheit (2) nach Anspruch 4 oder 5, wobei das obere Kontaktteil (48) der oberen TFLED-Kontaktstruktur (46) für Licht einer Wellenlänge, die durch den TFPD (5) detektierbar ist, mindestens teilweise transparent ist.

7. Licht-Emitter/Sensor-Einheit (2) nach einem der Ansprüche 4 bis 6, wobei das obere Kontaktteil (38) der oberen TFPD-Kontaktstruktur (36) näher an den Schaltungen (30) zum Regulieren einer Rückwandplatinenspannung als das obere Kontaktteil (48) der oberen TFLED-Kontaktstruktur (46) ist.

8. Licht-Emitter/Sensor-Einheit (2) nach einem der vorhergehenden Ansprüche, wobei die Schaltungen (30) zum Regulieren einer Rückwandplatinenspannung dazu konfiguriert sind, den TFPD (5) einzuschalten, indem sie eine erste Spannung zwischen der oberen und der unteren Seite (7) der Schicht (6) des TFPD (5) über die oberen und unteren TFPD-Kontaktstrukturen anlegen.

9. Licht-Emitter/Sensor-Einheit (2) nach einem der vorhergehenden Ansprüche, wobei die Licht-Emitter/Sensor-Einheit (2) ferner umfasst:
eine zweite TFLED (20), wobei die zweite TFLED (20) eine Schicht (26) mit einer oberen Seite (28) und einer unteren Seite (27) umfasst, wobei die Schicht (26) dazu konfiguriert ist, einen elektrischen Strom in Licht umzuwandeln;
wobei die Schaltungen (30) zum Regulieren einer Rückwandplatinenspannung ferner eine zweite TFLED-Kontaktfläche (42) umfassen, und wobei die Transistoren der Schaltungen (30) zum Regulieren einer Rückwandplatinenspannung ferner dazu konfiguriert sind, ein elektrisches Potential der zweiten TFLED-Kontaktfläche (42) einzustellen.

10. Licht-Emitter/Sensor-Einheit (2) nach Anspruch 9, wobei die erste (10) und die zweite (20) TFLED dazu konfiguriert sind, Licht zu emittieren, das unterschiedliche Spektren aufweist.

11. Anzeige (1), umfassend eine Anordnung (50) von Pixelbereichen (51), wobei mindestens einige Pixelbereiche (51) eine jeweilige Licht-Emitter/Sensor-Einheit (2) umfassen, die nach einem der vorhergehenden Ansprüche konfiguriert ist,
wobei sich die Licht-Emitter/Sensor-Einheiten (2) der Anzeige (1) gemeinsame Schaltungen zum Regulieren einer Rückwandplatinenspannung teilen, und
wobei die erste TFPD-Kontaktfläche (31), die zweite TFPD-Kontaktfläche (32) und die erste TFLED-Kontaktfläche (41) jeder Licht-Emitter/Sensor-Einheit (2) in den gemeinsamen Schaltungen zum Regulieren einer Rückwandplatinenspannung innerhalb des jeweiligen Pixelbereichs (51) jeder Licht-Emitter/Sensor-Einheit (2) enthalten sind.

12. Anzeige (1) nach Anspruch 11, wobei die oberen Kontaktteile, die mit den TFLEDs der Anordnung (50) verbunden sind, Teil einer gemeinsamen oberen TFLED-Kontaktstruktur sind.

13. Anzeige (1) nach Anspruch 12, wobei die Anzeige (1) dazu konfiguriert ist, eine TFLED eines Pixelbereichs (51) einzuschalten, indem sie eine zweite Spannung zwischen der oberen und der unteren Seite der Schicht der TFLED über die gemeinsame obere TFLED-Kontaktstruktur und den unteren TFLED-Kontakt der einen TFLED anlegt.

14. Verfahren (100) zum Herstellen eines Zwischenprodukts einer Anzeige (1), wobei das Verfahren (100) umfasst:
Bereitstellen (S102) von Schaltungen (30) zum Regulieren einer Rückwandplatinenspannung, die eine Anordnung (50) von Pixelbereichen (51) umfassen, wobei die Schaltungen (30) zum Regulieren einer Rückwandplatinenspannung eine erste (31) und eine zweite (32) TFPD-Kontaktfläche und eine erste TFLED-Kontaktfläche (41) in mindestens einigen Pixelbereichen (51) umfassen, wobei die Schaltungen (30) zum Regulieren einer Rückwandplatinenspannung ferner Transistoren umfassen, wobei die Transistoren dazu konfiguriert sind, ein elektrisches Potential der ersten TFLED-Kontaktfläche (41) einzustellen, und entweder die elektrischen Potentiale der beiden TFPD-Kontaktflächen einzustellen oder eine Potentialdifferenz zwischen den beiden TFPD-Kontaktflächen zu messen;
Bilden (S104, S106, S108), innerhalb mindestens einiger Pixelbereiche (51),
eines unteren TFPD-Kontakts (34), der aus der ersten TFPD-Kontaktfläche (31) vorsteht,
eines unteren TFPD-Kontaktteils (37), das aus der zweiten TFPD-Kontaktfläche (32) vorsteht, und
eines unteren TFLED-Kontakts (44), der aus der ersten TFLED-Kontaktfläche (41) vorsteht;
**dadurch gekennzeichnet, dass** das Verfahren ferner umfasst:
Bilden (S110), innerhalb mindestens einiger Pixelbereiche (51), eines Dünnschicht-Photodiodendetektors, TFPD, (5) auf und in elektrischem Kontakt mit dem unteren TFPD-Kontakt (34), wobei der TFPD (5) eine Schicht (6) mit einer oberen Seite (8) und einer unteren Seite (7) umfasst, wobei die Schicht (6) dazu konfiguriert ist, Licht zu absorbieren und das absorbierte Licht in Strom umzuwandeln; und
Bilden (S112), innerhalb mindestens einiger Pixelbereiche (51), eines oberen TFPD-Kontaktteils (38), das sich seitlich von dem unteren TFPD-Kontaktteil (37) bis zu einer Position über der oberen Seite (8) der Schicht (6) des TFPD (5) erstreckt und mit der oberen Seite (8) der Schicht (6) des TFPD (5) elektrisch verbunden ist, wodurch das obere (38) und das untere (37) Kontaktteil eine obere TFPD-Kontaktstruktur (36) bilden, welche die obere Seite (8) der Schicht (6) des TFPD (5) mit der zweiten TFPD-Kontaktfläche elektrisch verbindet.

## Revendications

1. Unité d'émetteur de lumière/capteur (2) pour un écran (1), l'unité d'émetteur de lumière/capteur (2) comprenant :
un détecteur à photodiode à couche mince, TFPD, (5) comprenant un film (6) avec un côté supérieur (8) et un côté inférieur (7), le film (6) étant configuré pour absorber la lumière et convertir la lumière absorbée en un courant,
une première diode électroluminescente à couche mince TFLED (10) comprenant un film (16) avec un côté supérieur (18) et un côté inférieur (17), le film (16) étant configuré pour convertir un courant électrique en lumière ;
des circuits de régulation de tension de fond de panier (30) comprenant des première (31) et deuxième (32) surfaces de contact TFPD, une première surface de contact TFLED (41) et des transistors, dans lequel les transistors sont configurés pour établir un potentiel électrique de la première surface de contact TFLED (41) et soit pour régler les potentiels électriques des deux surfaces de contact TFPD (31, 32), soit pour mesurer une différence de potentiel entre les deux surfaces de contact TFPD (31, 32) ;
dans lequel le côté inférieur (17) du film (16) du premier TFLED (10) est connecté électriquement à la première surface de contact TFLED (41), et dans lequel le côté inférieur (7) du film (6) du TFPD (5) est connecté électriquement à la première surface de contact TFPD (31) et au côté supérieur (8) du film (6) du TFPD (5) est connecté électriquement à la deuxième surface de contact TFPD (32) ;
**caractérisé en ce que** l'unité d'émetteur de lumière/capteur comprend en outre :
un contact inférieur du TFPD (34) qui dépasse en saillie depuis la première surface de contact du TFPD (31) et connecte électriquement la première surface de contact du TFPD (31) au côté inférieur (7) du film (6) du TFPD (5) ; et
une structure de contact TFPD supérieure (36) comprenant une partie de contact inférieure (37) qui dépasse en saillie depuis la deuxième surface de contact TFPD (32) et une partie de contact supérieure (38), qui s'étend latéralement depuis la partie de contact inférieure (37) jusqu'à une position au-dessus du côté supérieur du film (6) du TFPD (5) et se connecte au côté supérieur (8) du film (6) du TFPD (5), en connectant ainsi électriquement la face supérieure (8) du film (6) du TFPD (5) à la deuxième surface de contact TFPD (32) via les parties de contact supérieure (38) et inférieure (37).

2. Unité d'émetteur de lumière/capteur (2) selon la revendication 1, dans laquelle le premier TFLED (10) et le TFPD (5) sont disposés au-dessus du circuit de régulation de tension de fond de panier (30).

3. Unité d'émetteur/capteur de lumière (2) selon la revendication 2, dans laquelle la partie de contact supérieure (38) de la structure de contact supérieure du TFPD (36) est au moins partiellement transparente à la lumière d'une longueur d'onde qui est détectable par le TFPD (5).

4. Unité d'émetteur de lumière/capteur (2) selon une quelconque des revendications précédentes, comprenant en outre :
un contact TFLED inférieur (44) qui connecte électriquement la première surface de contact TFLED (41) au côté inférieur (17) du film (16) du premier TFLED (10); et
une structure de contact supérieure TFLED (46) comprenant une partie de contact supérieure (48), dans laquelle le côté supérieur (17) du film (16) du premier TFLED (10) est connecté électriquement à la partie de contact supérieure (48) de la structure de contact supérieure TFLED (46).

5. Unité d'émetteur/capteur de lumière (2) selon la revendication 4, dans laquelle la partie de contact supérieure (48) de la structure de contact supérieure TFLED (46) est au moins partiellement transparente à la lumière émise par le premier TFLED (10).

6. Unité d'émetteur/capteur de lumière (2) selon la revendication 4 ou 5, dans laquelle la partie de contact supérieure (48) de la structure de contact TFLED supérieure (46) est au moins partiellement transparente à la lumière d'une longueur d'onde qui est détectable par le TFPD (5).

7. Unité d'émetteur de lumière/capteur (2) selon une quelconque des revendications 4 à 6, dans laquelle la partie de contact supérieure (38) de la structure de contact TFPD supérieure (36) est plus proche du circuit de régulation de tension de fond de panier (30) que la partie de contact supérieure (48) de la structure de contact supérieure TFLED (46).

8. Unité d'émetteur de lumière/capteur (2) selon une quelconque des revendications précédentes, dans laquelle le circuit de régulation de tension du fond de panier (30) est configuré pour allumer le TFPD (5) en appliquant une première tension entre les côtés supérieur et inférieur (7) du film (6) du TFPD (5) via les structures de contact TFPD supérieure et inférieure.

9. Unité d'émetteur de lumière/capteur (2) selon une quelconque des revendications précédentes, dans laquelle l'unité d'émetteur de lumière/capteur (2) comprend en outre un deuxième TFLED (20), la deuxième TFLED (20) comprenant un film (26) avec un côté supérieur (28) et un côté inférieur (27), le film (26) étant configuré pour convertir un courant électrique en lumière, dans lequel le circuit de régulation de tension de fond de panier (30) comprend en outre une deuxième surface de contact TFLED (42), et dans lequel les transistors des circuits de régulation de tension de fond de panier (30) sont en outre configurés pour définir un potentiel électrique de la deuxième surface de contact TFLED (42).

10. Unité d'émetteur/capteur de lumière (2) selon la revendication 9, dans laquelle les première (10) et deuxième (20) TFLED sont configurées pour émettre de la lumière ayant des spectres différents.

11. Écran (1) comprenant un réseau (50) de zones de pixels (51), au moins certaines zones de pixels (51) comprenant une unité d'émetteur de lumière/capteur respective (2) configurée selon une quelconque des revendications précédentes, dans lequel les unités d'émetteur de lumière/capteur (2) de l'écran (1) partagent des circuits communs de régulation de tension de fond de panier, et dans lequel la première surface de contact TFPD (31), la deuxième surface de contact TFPD (32) et la première surface de contact TFLED (41) de chaque unité d'émetteur de lumière/capteur (2) sont comprises dans le circuit commun des circuits de régulation de tension de fond de panier, à l'intérieur de la zone de pixels respective (51) de chaque unité d'émetteur/capteur de lumière (2).

12. Écran (1) selon la revendication 11, dans lequel les parties de contact supérieures connectées aux TFLED du réseau (50) font partie d'une structure de contact supérieure commune TFLED.

13. Écran (1) selon la revendication 12, dans lequel l'écran (1) est configuré pour allumer un TFLED d'une zone de pixels (51) en appliquant une deuxième tension entre les côtés supérieur et inférieur du film de la TFLED via le structure de contact TFLED supérieure commune et le contact TFLED inférieur du TFLED.

14. Procédé (100) de production d'un produit intermédiaire d'un écran (1), le procédé (100) comprenant de :
fournir (S102) un circuit de régulation de tension de fond de panier (30) comprenant un réseau (50) de zones de pixels (51), dans lequel le circuit de régulation de tension de fond de panier (30) comprend une première (31) et une deuxième (32) surfaces de contact TFPD et une première surface de contact TFLED (41) dans au moins certaines zones de pixels (51), le circuit de régulation de tension de fond de panier (30) comprenant en outre des transistors, dans lequel les transistors sont configurés pour définir un potentiel électrique de la première surface de contact TFLED (41) et soit pour définir les potentiels électriques des deux surfaces de contact TFPD, soit pour mesurer une différence de potentiel entre les deux surfaces de contact TFPD ;
former (S104, S106, S108), à l'intérieur desdites au moins certaines zones de pixels (51), un contact TFPD inférieur (34) qui dépasse de la première surface de contact TFPD (31), une partie de contact TFPD inférieure (37) qui dépasse de la deuxième surface de contact TFPD (32), et
un contact TFLED inférieur (44) qui dépasse de la première surface de contact TFLED (41), **caractérisé en ce que** le procédé comprend en outre de :
former (S110), à l'intérieur desdites au moins certaines zones de pixels (51), un détecteur à photodiode à couche mince, TFPD, (5) au-dessus et en contact électrique avec le contact inférieur TFPD (34), le TFPD (5) comprenant un film (6) avec une face supérieure (8) et une face inférieure (7), le film (6) étant configuré pour absorber la lumière et pour convertir la lumière absorbée en un courant ; et
former (S112), à l'intérieur desdites au moins certaines zones de pixels (51), une partie de contact supérieur TFPD (38) qui s'étend latéralement à partir de la partie de contact TFPD inférieur (37) vers une position au-dessus du côté supérieur (8) du film (6) du TFPD (5) et se connecte électriquement avec le côté supérieur (8) du film (6) du TFPD (5), moyennant quoi les parties de contact supérieure (38) et inférieure (37) forment une structure de contact TFPD supérieure (36) qui connecte électriquement le côté supérieur (8) du film (6) du TFPD (5) à la deuxième surface de contact du TFPD.
